# EUROPÄISCHE PATENTSCHRIFT

(11) **EP 1 794 344 B1**
(45) Veröffentlichungstag und Bekanntmachung des Hinweises auf die Patenterteilung: **19.10.2011**
(21) Anmeldenummer: 05792476.3
(22) Anmeldetag: 16.09.2005
(51) Int. Cl.: C23C 14/24

(54) **HERRICHTEN UND BETREIBEN EINES VERDAMPFERKÖRPERS FÜR EINE PVD-METALLISIERUNGSANLAGE**
PREPARING AND OPERATING A VAPORIZER BODY FOR A PVD METALLIZATION INSTALLATION
PREPARATION ET EXPLOITATION D'UN CORPS DE VAPORISATION POUR INSTALLATION DE METALLISATION PAR DEPOT EN PHASE GAZEUSE PAR PROCEDE PHYSIQUE

(30) Priorität: 17.09.2004 DE 102004045206
(43) Veröffentlichungstag der Anmeldung: 13.06.2007
(73) Patentinhaber: Kennametal Sintec Keramik GmbH, 86956 Schongau (DE)
(72) Erfinder: NÜRNBERGER, Michael, 86956 Altenstadt (DE); MAIZINGER, Rudolf, 86956 Schongau (DE); GOETZ, Ulrich, 87642 Halblech (DE)
(74) Vertreter: Freier, Rüdiger
(86) Internationale Anmeldenummer: PCT/DE2005/001631
(87) Internationale Veröffentlichungsnummer: WO 2006/029615

(56) Entgegenhaltungen:
- EP-A- 0 337 391
- DE-A1- 2 535 569
- GB-A- 1 263 088
- US-A- 3 216 710
- US-A- 4 528 120

## Beschreibung

Die Erfindung betrifft das Herrichten eines Verdampferkörpers, insbesondere eines keramischen Verdampferkörpers, und dessen Betreiben in einer PVD-Metallisierungsanlage, insbesondere eine Metallisierungsanlage zum kontinuierlichen Beschichten eines flexiblen Substrats. Auf der Oberseite des Verdampferkörpers ist eine von der Metallschmelze benetzbare Schichtstruktur angeordnet, die sich entlang des Verdampferkörpers im Abstand von dessen Enden zur Ausbildung der Verdampferfläche des Verdampferkörpers erstreckt.

Das gebräuchliche Verfahren zum Beschichten von flexiblen Substraten mit Metallen ist das sog. Vakuum-Bandmetallisieren gemäß der PVD (physical vapor deposition)-Technik. Als flexible Substrate kommen z.B. Papier, Kunststoffolien und Textilien in Frage und als Metall wird überwiegend Aluminium eingesetzt. So beschichtete Substrate finden breite Anwendung für Verpackung-, Dekorationszwecke, bei der Kondensatorherstellung und in der Umwelttechnik (Isolation).

Die Beschichtung der flexiblen Substrate erfolgt in sog. Metallisierungsanlagen. In der Metallisierungsanlage wird das zu beschichtende Substrat über eine gekühlte Walze geführt und dabei einem Metalldampf ausgesetzt, der sich auf der Substratoberfläche als dünne Metallschicht niederschlägt. Zur Erzeugung des erforderlichen konstanten Dampfstromes werden widerstandsbeheizte Verdampferkörper insbesondere in Form sogenannter Verdampferschiffchen eingesetzt, die im direkten Stromdurchgang auf etwa 1450-1600°C erhitzt werden. Metalldraht wird kontinuierlich zugeführt, auf der Oberfläche der Verdampferschiffchen verflüssigt und im Vakuum bei ca. 10⁻⁴ mbar verdampft. Als Metall wird hauptsächlich Aluminium eingesetzt.

Derartige Verdampferkörper bestehen in der Regel aus heißgepreßtem keramischem Material, das als Hauptkomponente Titandiborid und Bornitrid und/oder Aluminiumnitrid enthält. Titandiborid ist dabei die elektrisch leitfähige Komponente, Bornitrid und/oder Aluminiumnitrid die elektrisch isolierende Komponente, die miteinander gemischt zu spezifischen Heiß-Widerständen von 600-6000 µOhm*cm führen, wobei ein Mischungsverhältnis von leitfähiger zu nichtleitfähiger Komponente von je 50 Gew% (+/- 10 Gew%) vorliegt.

Flüssiges Aluminium verursacht während des Metallisierungsprozesses auf dem Verdampferschiffchen Korrosion und Erosion, wodurch die nutzbare Lebensdauer des Verdampferschiffchens begrenzt wird. Auswaschungen von tiefen Gräben in der Umgebung des Aluminium-Drahtauftreffpunktes und Schwierigkeiten bei der Kontrolle der optimalen Temperaturverteilung über die Verdampferoberfläche während des Metallisierens sind typische Ausfallgründe. Weiterhin stellt die Benetzung, vor allem die Erstbenetzung, der Verdampferschiffchen mit dem zu bedampfenden Metall ein Problem dar. Von der Benetzungsfähigkeit des zu verdampfenden Metalls wird auch die maximale Abdampfrate (kg Metall pro Zeiteinheit) beeinflußt.

Die Benetzung mit Kupfer oder Silber bereitet aufgrund der ungünstigen Benetzungseigenschaften der beiden Metalle auf der Titandiborid-Bornitrid-Mischkeramik große Schwierigkeiten.

Daher wird im Stand der Technik auf den Verdampferkörper eine ein- oder mehrschichtige Schichtstruktur aufgebracht, auf welche das Metall zugeführt wird, um Korrosion und Erosion des Verdampferkörpers weitgehend zu vermeiden und dadurch die Lebensdauer des Verdampferkörpers zu erhöhen und die Benetzbarkeit je nach dem verwendeten Metall zu fördern. Die bekannten Schichtstrukturen sind als Dauerbeschichtung ausgelegt.

Beispielsweise ist es aus der DE 195 16 233 C1 bekannt, die Abriebsfestigkeit der Beschichtung eines keramischen oder metallischen Verdampfungskörpers für den Einsatz in der PVD-Beschichtungstechnik zu erhöhen durch Aufbringen mindestens einer Schicht aus einem hochschmelzenden Borid oder Carbid oder Nitrid oder Silicid der IV., V. und VI. Nebengruppe des Periodensystems der Elemente, oder einer stabilen Mischphase dieser Verbindungen oder einer stabilen Mischphase dieser Verbindungen mit Aluminiumnitrid, und wahlweise einer elektrisch isolierenden Schicht aus einem hochschmelzenden Oxid. Diese Beschichtung wird durch CVD-Verfahren, Zerstäubungsprozesse (Sputterprozesse) oder Ionenplattieren aufgebracht und hat eine Gesamtdicke bei einem dreischichtigen Aufbau von 12 µm bis 45 µm.

Auch ist es aus der DE 25 03 374 bekannt, ein Kohlenstoffschiffchen für die Aluminiumverdampfung ganz oder teilweise mit einer Schutzschicht aus refraktionären Metallen und/oder aus deren Nitriden zu überziehen, so daß sich das Ausdehnungsverhalten der Schutzschicht mit demjenigen des Kohlenstoffmaterials verträgt und die Gefahr eines Abplatzens der Schutzschicht während des Verdampfungsvorgangs verringert wird. Hierzu wird die Schutzschicht in einem Flamm- oder Plasmaspritzverfahren oder durch chemische Gasphasenabscheidung aufgebracht, wobei eine möglichst enge Haftung der Schutzschicht an dem Kohlenstoffsubstrat durch vorheriges Aufrauhen der Substratoberfläche angestrebt wird.

Nach der DE 31 14 467 A wird ebenfalls angestrebt, besonders gut haftende Schichten zu erzielen, indem Verdampferschiffchen aus feuerfester Oxidkeramik für die Verdampfung von Metallen wie Kupfer, Eisen, Nickel oder Legierungen dieser Metalle mit einer Beschichtung aus Wolfram und/oder Molybdän versehen werden. Diese Beschichtung wird im Flammspritz- oder Plasmaspritzverfahren aufgebracht, um ein örtliches Abplatzen wie bei Schichten zu vermeiden, die aus aufgesintertem Wolfram- und/oder Molybdän-Pulver hergestellt worden sind.

EP 0 337 391 A offenbart ein Verdampferschiffchen zum Verdampfen von geschmolzenem Metall wie zum Beispiel Aluminium, wobei das Verdampferschiffchen an seiner Oberfläche mit einer benetzungsfördernden Titan-Eisen-Silizium-Beschichtung versehen ist. Diese Beschichtung wird erzeugt durch Bereitstellen einer Suspension, enthaltend Titan-, Eisen- und Siliziumpulver sowie ein Dispersionsmittel und ein Bindemittel, Aufstreichen der Suspension auf das Verdampferschiffchen und anschließendes Erwärmen des Verdampferschiffchens.

Gemäß der vorliegenden Erfindung werden ein Verfahren zum Herrichten und Betreiben eines Verdampferkörpers nach Anspruch 1, ein Verfahren zum Herrichten und Betreiben eines Verdampferkörpers nach Anspruch 16, ein Verfahren zum Herrichten und Betreiben eines Verdampferkörpers nach Anspruch 23 sowie eine vorgefertigte Platte nach Anspruch 19 bereitgestellt. Weitere Ausführungsformen der vorliegenden Erfindung sind in den jeweiligen abhängigen Ansprüchen beschrieben.

Durch die Erfindung wird erreicht, bei der PVD-Metallisierung durch verbesserte Benetzung der Verdampferfläche mit dem jeweiligen zu verdampfenden Metall eine hohe Abdampfrate zu erzielen, die Standzeit des Verdampferkörpers oder Verdampferschiffchens zu erhöhen und dessen elektrische Kontrolle zu verbessern, so daß die Qualität des aufgedampften Metallfilms auf dem insbesondere flexiblen Substrat erhöht ist.

Gegenstand der Erfindung ist insbesondere ein Verfahren zum Herrichten eines Verdampferkörpers und dessen Betreiben in einer PVD-Metallisierungsanlage, wobei zur Ausbildung der Verdampferfläche für das Abdampfen des Metalls auf den Verdampferkörper eine Schichtstruktur aus mindestens einer Schicht aufgebracht wird und ein Metallisierungszyklus durchgeführt wird, in welchem der Verdampferkörper mit elektrischem Strom betrieben wird und kontinuierlich mit Metall beschickt wird, so daß der Verdampferkörper aufgrund seines elektrischen Widerstands erwärmt wird und das der Schichtstruktur zugeführte Metall verdampft wird. Gemäß der Erfindung wird als Schichtstruktur eine durch den Betrieb des Verdampferkörpers verbrauchbare Schichtstruktur verwendet, die auf den Verdampferkörper vor dem Metallisierungszyklus als Rohschichtstruktur in Form einer vorgefertigten Platte aus sinterfähigem Pulvermaterial im im wesentlichen unversinterten Zustand aufgebracht wird und in dem Metallisierungszyklus durch die Erwärmung des Verdampferkörpers auf diesen aufgesintert wird.

In einer Verfahrensvariante weist die in Form einer vorgefertigten Platte vorliegende Rohschichtstruktur ein sinterfähiges Pulvermaterial im im wesentlichen unversinterten Zustand in einem niedrigschmelzenden Bindermaterial auf, in dem das sinterfähige Pulvermaterial verteilt vorliegt.

Als sinterfähiges Pulvermaterial kann dabei ein geeignetes körniges Material aus Einzelkörnchen und/oder Korn-Agglomeraten und/oder einer körnigen Fraktion aus vorgesintertem Material verwendet werden. Das Aufsintern des Pulvermaterials auf den Verdampferkörper erfolgt insbesondere dadurch, daß Schmelzbrücken zwischen der Materialstruktur des Verdampferkörpers und der Kornstruktur des Pulvermaterials entstehen, um für einen ausreichend guten Wärmeübergang zwischen Verdampferkörper und Schicht zu sorgen, wobei die Schmelzbrücken gegebenenfalls aus Sinterhilfsstoffen und/oder aus Reaktionsprodukten mit dem zu verdampfenden Metall sein können.

Anders als bei den bekannten Verfahren wird gemäß der Erfindung die als Schutz des Verdampferkörpers gegen Erosion aufgebrachte Schichtstruktur aus einer oder mehreren Schichten nicht für eine möglichst hohe Abriebsfestigkeit und dauerhafte Haftung auf dem Material des Verdampferkörpers, sondern als ein sogenannter Opferüberzug ausgelegt, der sich zwar während des Metallisierungsvorgangs durch erosionsbedingten Abrieb und erosionsbedingte Ausschwemmung verbraucht, jedoch bis dahin eine gute Benetzbarkeit durch das verflüssigte und zu verdampfende Metall aufweist und daher für eine hohe und gut regelbare Abdampfrate bei gleichmäßiger Abdampfdichte sorgt.

Da das die Rohschichtstruktur bildende Pulvermaterial erst durch das Aufheizen des Verdampferkörpers und/oder während des Metallisierungsvorgangs auf den Verdampferkörper aufsintert und dabei auch selbst versintert wird, entsteht bei gleichzeitig hoher Benetzungs- und Aufnahmefähigkeit für das zu verdampfende Metall eine für den Metallisierungszyklus ausreichend gute temporäre Haftung der Schichtstruktur zum Verdampferkörper und unter den Teilchen der Schichtstruktur bei hinreichend gutem Wärmeübergang zwischen Verdampferkörper und Schichtstruktur. Nach der Beendigung des Metallisierungszyklus, dessen Dauer von dem Verbrauchsgrad der Schichtstruktur bestimmt wird, läßt sich die verbrauchte Schichtstruktur relativ leicht wieder von dem abgekühlten Verdampferkörper wenigstens teilweise entfernen und durch eine frische Rohschichtstruktur wenigstens an denjenigen Stellen ersetzen, an denen sich die verbrauchte Schichtstruktur von dem Verdampferkörper durch dessen Abkühlen abgelöst hat, wonach ein weiterer Metallisierungszyklus eingeleitet werden kann. Das Entfernen der verbrauchten Schichtstruktur und deren Ersetzen wird vorzugsweise in der Metallisierungsanlage ohne Demontage des Verdampfungskörpers durchgeführt. Der Verdampferkörper als solcher kann daher für eine lange Standzeit in wiederholten Metallisierungszyklen wiederverwendet werden.

Aus DE 25 35 569 A ist es an sich bekannt, die mit dem geschmolzenen Metall in Berührung kommende Verdampferfläche eines keramischen Verdampferkörpers mit einem Karbid oder mit Wolframmetall, Tantalmetall oder Molybdänmetall zu beschichten, um eine gute Benetzbarkeit der Beschichtung durch das geschmolzene Metall zu erreichen. Hierbei kann die Beschichtung durch Aufspritzen aus der Schmelze, in einem Verdampfungsbeschichtungsverfahren oder auch in einer Beschichtungs-Trocknungsmethode aufgebracht werden. Bei letzterer wird eine Suspension von Pulver aus dem jeweiligen Karbid oder Metall in einem verdampfbaren Medium z.B. mit einer Bürste aufgebracht und anschließend getrocknet und gesintert. Die Trocknung soll vorzugsweise bei 60 °C bis 200 C° durchgeführt werden und die Sinterung bei 200 °C bis 1000 °C erfolgen. Jedoch wird nicht über Zeitpunkt, Ort und Qualität der Sinterung berichtet. Nach den Beispielen handelt es sich außerdem nicht um einen Verdampferkörper für eine Beschichtung, bei welcher die Zuführung des zu verdampfenden Metalls kontinuierlich erfolgt, zumal von relativ kurzen Verdampfungszyklen von 25 bis 322 s ausgegangen wird, bei welchen eine gute Korrosionsfestigkeit des Keramikmaterials des Verdampferkörpers besteht.

Demgegenüber wird bei dem erfindungsgemäßen Verfahren das zu verdampfende Metall in Form eines Drahtes kontinuierlich zugeführt, wobei der Metallisierungszyklus je nach Material der Schichtstruktur und Höhe der Abdampfrate 30 bis 90 min dauern kann.

Wenngleich die erfindungsgemäße Rohschichtstruktur auf einen Verdampferkörper ohne Kavität aufgebracht werden kann, ist der Verdampferkörper in weiterer Ausgestaltung der Erfindung mit einer Kavität ausgestattet, in welche das die Rohschichtstruktur bildende ungesinterte Pulvermaterial eingebracht wird. Vorzugsweise hat die Kavität einen flachen hohlen Rechteckquerschnitt, der mit dem Pulvermaterial bis auf eine Restkavität mit einer Tiefe von 0,3 bis 3 mm, vorzugsweise von 0,5 bis 0,8 mm ausgefüllt wird, damit ein Ausbreiten der Schmelze begrenzt wird.

Die Rohschichtstruktur wird auf den Verdampferkörper in Form einer ein- oder mehrschichtigen vorgefertigten, z.B. verpreßten oder auch leicht vorgesinterten Platte aus dem Pulvermaterial aufgebracht. Der Verdampferkörper kann dabei mit einer Kavität ausgestattet sein, in welche die Platte eingelegt wird.

Die erfindungsgemäße Schichtstruktur kann einschichtig oder aus mehreren übereinanderliegenden Schichten zusammengesetzt sein. In der einschichtigen Struktur kann das sinterfähige Pulvermaterial ohne oder mit zusätzlichem Bindermaterial vorliegen. Auch bei Verwendung von mehreren übereinander liegenden Schichten können in beiden Schichten sinterfähige Pulvermaterialien jeweils zusammen mit dem niedrigschmelzenden Bindermaterial oder ohne das niedrigschmelzende Bindermaterial vorliegen, oder das Bindermaterial ist in nur einer der Schichten, bevorzugt nur in der oberen Schicht enthalten.

Durch die Erfindung ist es auch möglich, eine relativ dicke ein- oder mehrschichtige Schichtstruktur vorzusehen, um deren Aufnahmevermögen für das flüssige Metall zu steigern und dadurch hohe Abdampfraten erzielen zu können. So kann die erfindungsgemäße Schichtstruktur eine Gesamtdicke von 0,2 bis 1,5 mm, vorzugsweise von 0,6 bis 1,0 aufweisen.

Während im Stand der Technik für eine möglichst gute Haftfähigkeit angestrebt wird, das Wärmeausdehnungsverhalten einer auf den Verdampfungskörper aufgebrachten Schichtstruktur an das Substratmaterial des Verdampferkörpers möglichst eng anzupassen, kann es gemäß der Erfindung vorteilhaft sein, eine Schichtstruktur mit einem Wärmeausdehnungskoeffizienten insbesondere an der mit dem Substratmaterial des Verdampfungskörpers in Kontakt stehenden Schicht zu verwenden, die von dem Wärmeausdehnungskoeffizienten des Verdampferkörpers verschieden ist, so daß ein Ablösen und Abplatzen der im Metallisierungszyklus verbrauchten Schichtstruktur durch das Abkühlen des Verdampferkörpers am Ende des Metallisierungszyklus begünstigt wird. Nicht durch das Abkühlen abgelöste Reste der Schichtstruktur lassen sich im allgemeinen mühelos durch Abbürsten oder Abschaben entfernen, was auch in der Metallisierungsanlage selbst durchgeführt werden kann.

Als Grundmaterial des elektrisch beheizten Verdampferkörpers, insbesondere Verdampferschiffchens, wird gemäß der Erfindung bevorzugt eine Mischkeramik mit den Hauptkomponenten TiB₂, BN und/oder A1N oder eine Keramik-Metall-Mischung mit den Hauptkomponenten ZrO₂ und Mo oder ein Material mit Kohlenstoff als Hauptkomponente verwendet.

Vorzugsweise weist eine erfindungsgemäße Schichtstruktur im einschichtigen Aufbau oder mehrschichtigen Aufbau eine an der Oberseite der Schichtstruktur freiliegende, in Anpassung an das zu verdampfende Metall benetzungsfördernde Schicht auf aus einem hochschmelzenden Borid oder Carbid oder Nitrid oder Silicid der IV, V und VI Nebengruppe, insbesondere Titandiborid, oder einer stabilen Mischphase wenigstens zweier dieser Verbindungen oder einer stabilen Mischphase wenigstens einer dieser Verbindungen mit Aluminiumnitrid oder Molybdän oder Wolfram oder Titan oder Zirkonoxid (ZrO₂) Bei einem mehrschichtigen Aufbau der Schichtstruktur wird vorzugsweise als unterste, mit dem Verdampferkörper in Kontakt stehende Schicht, oder als eine Zwischenschicht, eine benetzungshemmende und/oder elektrisch isolierende Schicht aus der Gruppe aus Bornitrid, Aluminiumnitrid, hochschmelzende Oxide wie Aluminiumoxid (Al₂O₃) und Yttriumoxid, Siliziumnitrid, Aluminiumtitanat, Zirkonsilikat oder Mischphasen zweier oder mehr dieser Verbindungen aufgetragen.

Zum Verdampfen von Aluminium kann auf den Verdampferkörper ein Einschichtaufbau oder ein Mehrschichtaufbau mit einem benetzungsfähigen Überzug vorzugsweise aus einem hochschmelzenden Borid oder Carbid oder Nitrid oder Silicid der IV, V und VI Nebengruppe des Periodensystems, insbesondere Titandiborid, oder einer stabilen Mischphase wenigstens zweier dieser Verbindungen oder einer stabilen Mischphase wenigstens einer dieser Verbindungen mit Aluminiumnitrid oder Zirkonoxid (ZrO₂ verwendet werden. Bei einem Mehrschichtaufbau mit einer benetzungshemmenden oder isolierenden untersten Schicht ist diese vorzugsweise aus der Gruppe aus Bornitrid, Aluminiumnitrid, Siliziumnitrid, hochschmelzende Oxide (wie Aluminiumoxid (Al₂O₃) oder Yttriumoxid), Aluminiumtitanat, Zirkonsilikat oder aus einer Mischphase wenigstens zweier dieser Verbindungen.

Zum Verdampfen von Kupfer, Zinn, Silber oder Gold wird auf den Verdampferkörper ein Einschichtaufbau oder ein Mehrschichtaufbau vorzugsweise mit einer benetzungsfähigen Schicht aus Wolfram, Molybdän oder vorzugsweise Titan oder einer Mischung dieser Komponenten aufgetragen, wobei bei einem Mehrschichtaufbau eine benetzungshemmende oder isolierenden unterste oder mittlere Schicht vorzugsweise aus Bornitrid, Aluminiumnitrid, Siliziumnitrid, hochschmelzende Oxide (wie Aluminiumoxid (Al₂O₃) oder Yttriumoxid), Aluminiumtitanat oder Zirkonsilikat, oder Mischphasen dieser Verbindungen aufgetragen ist.

Bei der bereits erwähnten Verfahrensvariante, bei welcher die Rohschichtstruktur aus einem sinterfähigen Pulvermaterial im im wesentlichen unversinterten Zustand in einem niedrigschmelzenden Bindermaterial vorliegt, in dem das sinterfähige Pulvermaterial verteilt ist, kann das Bindermaterial selbst als Pulvermaterial im Gemisch mit dem sinterfähigen Pulvermaterial vorliegen. Ein solches Gemisch kann verpreßt, insbesondere warmverpreßt sein. Das Bindermaterial kann jedoch auch mit dem Bindermaterial verschmolzen sein, so dass von dem Bindermaterial eine Gußstruktur gebildet wird, in welche das sinterfähige Pulvermaterial in gleichmäßiger oder ungleichmäßiger Verteilung eingebettet ist.

Vorzugsweise ist das niedrigschmelzende Bindermaterial ein Material mit hoher Wärmeleitfähigkeit und derart ausgewählt, dass es auch im geschmolzenen Zustand nicht mit dem sinterfähigen Pulvermaterial reagiert und daher im wesentlichen keine Reaktionsprodukte bildet.

Bei dieser Verfahrensvariante ist die das niedrigschmelzende Bindermaterial enthaltende Schicht bevorzugt als vorgefertigte Platte ausgebildet.

Bei der Erwärmung des Verdampferkörpers schmilzt das Bindermaterial, so dass das darin verteilte sinterfähige Pulvermaterial darin suspendiert wird und sedimentiert, so daß ein guter Wärmekontakt des sinterförmigen Pulvermaterials mit dem Verdampferkörper entsteht. Mit zunehmender Erwärmung verdampft das Bindermaterial vollständig, ohne an dem Sinterprozeß aktiv teilzunehmen.

Mit Vorteil wird als Bindermaterial Zinn oder gebundenes Zinn oder eine Zinnlegierung beigemischt, wobei Verunreinigungen vorliegen können. Hierbei wird insbesondere Zinn als Bindermaterial vorgezogen, weil das Intervall zwischen seinem Schmelzpunkt bei 230 Celsiusgrad und seiner Verdampfungstemperatur bei 1200 bis 1400 Celsiusgrad groß ist und daher die gute Wärmeleitfähigkeit des geschmolzenen Zinns für eine rasche und gleichmäßige Erwärmung des sinterfähigen Pulvermaterials für dessen Versinterung ausgenutzt wird.

Die Erfindung betrifft in einer zweiten Verfahrensvariante auch ein Verfahren zum Herrichten eines Verdampferkörpers, insbesondere eines keramischen Verdampferkörpers, und dessen Betreiben in einer PVD-Metallisierungsanlage, bei welchem auf den Verdampferkörper eine Schichtstruktur aus mindestens zwei Schichten aufgebracht wird und ein Metallisierungszyklus durchgeführt wird, in welchem der Verdampfungskörper mit elektrischem Strom betrieben wird und kontinuierlich mit Metall beschickt wird, so daß der Verdampfungskörper aufgrund seines elektrischen Widerstands erwärmt wird und das auf die Schichtstruktur zugeführte Metall verflüssigt und verdampft wird. Auch bei dieser zweiten Verfahrensvariante wird als Schichtstruktur eine durch den Betrieb des Verdampferkörpers verbrauchbare Schichtstruktur verwendet, die auf den Verdampferkörper vor dem Metallisierungszyklus als Rohschichtstruktur aufgebracht wird, die eine obere Schicht aus einem benetzungsfördernden Plattenmaterial und eine untere elektrische isolierende und/oder benetzungshemmende Schicht aus sinterfähigem Pulvermaterial im im wesentlichen unversinterten Zustand aufweist, und in dem Metallisierungszyklus durch die Erwärmung des Verdampfungskörpers auf diesen aufgesintert wird.

Bei dieser zweiten Verfahrensvariante kann als die obere Schicht eine weitgehend homogene Platte verwendet werden, die insbesondere aus einem der benetzungsfördernden Materialien ist, die für die anderen weiter oben beschriebenen Verfahrensvarianten angegeben sind, wohingegen die untere Schicht aus einem benetzungshemmenden und/oder elektrisch isolierenden Pulvermaterial der für die erste Verfahrensvariante angegeben Zusammensetzung ist.

Es ist jedoch auch möglich, dieses Plattenmaterial ebenfalls als Rohschichtstruktur aus sinterfähigem, jedoch unversinterten Pulvermaterial zu gestalten, das bevorzugt in Zinn als Bindermaterial vorliegen kann.

Die weiter oben geschilderten Merkmale können entsprechend auch für die zweite Verfahrensvariante in Anpassung an die Verwendung einer weitestgehend homogenen Platte als obere Schicht der Schichtstruktur verwendet werden.

Bei allen Verfahrensvarianten kann das Auftragen einer mehrschichtigen Rohschichtstruktur durch Einbringen der unteren Schicht in wannenförmiger Gestalt in eine Kavität des Verdampfungskörpers und durch Einbringen der oberen Schicht in die wannenförmige untere Schicht erfolgen, so daß die obere Schicht an der Unterseite und entlang ihres Umfangs von der unteren Schicht umgeben ist. Hierdurch wird weitgehend verhindert, daß die Schichtstruktur ebenfalls von dem den Verdampferkörper erwärmenden Strom durchflossen wird.

Ein mit der Rohschichtstruktur vorbeschichteter Verdampferkörper ist insbesondere für die Erstbenetzung desselben vorteilhaft und kann im vorbeschichteten, getrockneten und ggf. leicht vorgesinterten Zustand an Abnehmer geliefert werden.

Weiter betrifft die Erfindung eine sinterfähige Rohschichtstruktur in Form einer vorgefertigten Platte zum Aufbringen auf einen elektrisch betreibbaren, insbesondere keramischen Verdampferkörper für eine PVD-Metallisierungsanlage. Von dieser vorgefertigten Platte (im folgenden auch "Rohpulverplatte") wird eine erfindungsgemäße ein- oder mehrschichtige Rohschichtstruktur aus sinterfähigem Pulvermaterial im im wesentlichen unversinterten Zustand oder aus sinterfähigem Pulvermaterial im im wesentlichen unversinterten Zustand in einem niedrigschmelzenden Bindermaterial ausgebildet, in dem das sinterfähige Pulvermaterial verteilt ist.

In bevorzugter Ausführungsform liegt die vorgefertigte Platte als Schichtstruktur mit sinterfähigem Pulvermaterial in im wesentlichen unversinterten Zustand in einem Bindermaterial vor, wie dies im Zusammenhang mit der ersten Verfahrensvariante weiter oben bereits beschrieben wurde. Auch hierbei wird als Bindermaterial vorzugsweise Zinn hergenommen, welches als Pulverkomponente im Gemisch mit dem Sinterpulver vorliegen kann und mit diesem unter Ausbildung der vorgefertigten Platte verpreßt, insbesondere warmverpreßt sein kann. Mit Vorteil kann das Zinn statt als Pulverkomponente als Gußkomponente ausgebildet sein, in welcher das Sinterpulver in mehr oder weniger gleichmäßiger Verteilung vergossen ist.

Die vorgefertigte Platte ist vorzugsweise als Einschichtplatte ausgebildet, wobei das sinterfähige Pulvermaterial ein für das zu verdampfende Metall benetzungsförderndes Material oder Materialgemisch ist, das eine der weiter oben für das Verfahren beschriebenen Zusammensetzungen hat. Die vorgefertigte Platte kann aber auch eine Zweischichtstruktur haben, in welcher die untere Schicht benetzungshemmend und/oder elektrisch isolierend ausgebildet ist und als dünne Beschichtung auf die Unterseite der oberen Schicht oder auf die Unterseite und die Seitenflächen der Rohpulver-Zinn-Platte, insbesondere in Form einer Suspension aufgestrichen, aufgetragen ist.

Die Platte kann insbesondere in Anpassung an den jeweiligen Verdampferkörper, der ohne oder bevorzugt mit Kavität ausgebildet ist, geformt oder zugeschnitten sein, so daß sie für den Erstbetrieb des Verdampfungskörpers unmittelbar, oder für dessen Wiederholungsbetrieb nach Ablösung der im vorangegangenen Betrieb verbrauchten Schichtstruktur auf den Verdampferkörper aufgelegt werden kann.

Ein besonderer Vorteil in der Verwendung des Zinns als Bindermaterial zum Formen der Rohpulver-Platte liegt darin begründet, dass das Zinn ein sehr großes Schmelz-Verdampfungs-Intervall aufweist, d.h. Zinn weist einen niedrigen Schmelzpunkt und eine relativ hohe Siedetemperatur auf. Da die Siedetemperatur des Zinns oberhalb der Sintertemperatur des Rohpulvers liegt, liegt das Rohpulver vor Beginn und zu Beginn des Sinterprozesses in der Zinnschmelze suspendiert vor. Dadurch wird ein Haften/Festhalten der Rohpulverpartikel auf der Verdampferoberfläche bzw. in der Kavität des Verdampferschiffchens sichergestellt und verhindert, dass die Rohpulverpartikel von der Verdampferoberfläche vorzeitig abgetragen werden. Ferner weist die Zinnschmelze sehr gute Eigenschaften hinsichtlich der Wärmeübertragung und Wärmeverteilung auf.

Zudem verhält sich das Zinn gegenüber dem sinterfähigen Rohpulver neutral, d.h. es geht keine Reaktion mit diesem ein. Gemäß einer dritten Verfahrensvariante betrifft die Erfindung auch ein Verfahren zum Herrichten eines Verdampferkörpers, insbesondere eines keramischen Verdampferkörpers, und dessen Betreiben in einer PVD-Metallisierungsanlage, bei welchem auf den Verdampferkörper eine Schichtstruktur aus mindestens einer Schicht aufgebracht wird und ein Metallisierungszyklus durchgeführt wird, in welchem der Verdampfungskörper mit elektrischem Strom betrieben wird und kontinuierlich mit Metall beschickt wird, so daß der Verdampfungskörper aufgrund seines elektrischen Widerstands erwärmt wird und das der Schichtstruktur zugeführte Metall verdampft wird, wobei als Schichtstruktur eine durch den Betrieb des Verdampferkörpers verbrauchbare Schichtstruktur verwendet wird, die auf den Verdampferkörper vor dem Metallisierungszyklus als Rohschichtstruktur aus in einem niedrigschmelzenden Bindermaterial aus Zinn verteilten sinterfähigen Pulvermaterial im im wesentlichen unversinterten Zustand aufgebracht wird und in dem Metallisierungszyklus durch die Erwärmung des Verdampfungskörpers auf diesen aufgesintert wird.

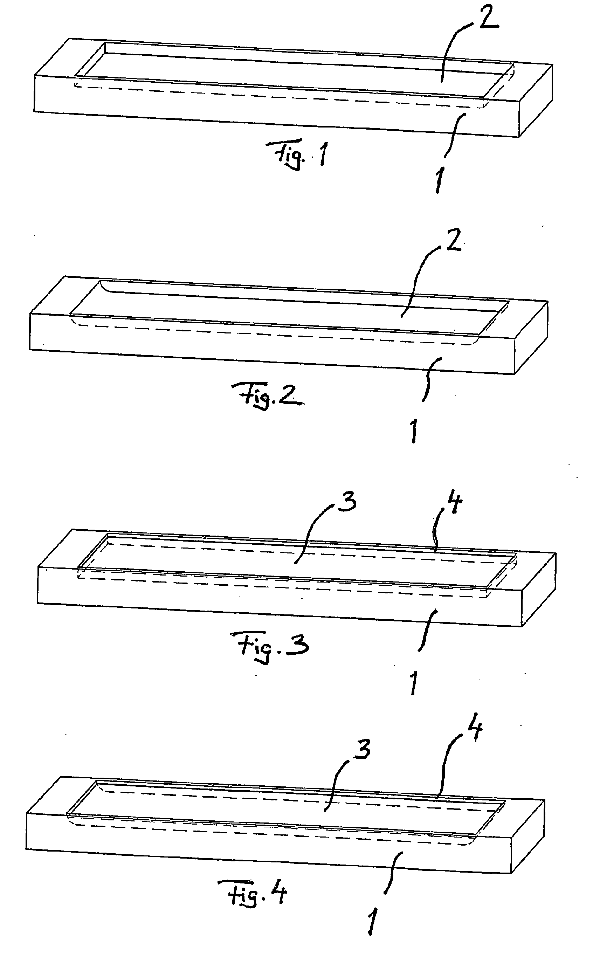

Aus der Zeichnung sind bevorzugte Ausführungsformen eines Verdampferkörpers 1 in Form eines typischen Verdampferschiffchens mit einer flachen Kavität 2 mit hohlem Rechteckquerschnitt schematisch ersichtlich. Bei der Ausführungsform aus Fig. 1 sind die Begrenzungsflächen der Kavität 2 an beiden Seiten derselben und an deren Vorder- und Rückseite eben und senkrecht zum Boden der Kavität ausgebildet. Bei der Ausführungsform aus Fig. 2 hingegen entsprechen die seitlichen Begrenzungsflächen der Kavität denen aus Fig. 1, wohingegen die vordere und die hintere Begrenzungsfläche schräg nach außen zum Boden geneigt verlaufen und am Übergang zum Boden ausgerundet sind. Hierdurch wird insbesondere ein Herausschaben oder Herausbürsten des verbrauchten Überzuges aus der Kavität 2 begünstigt.

Aus den Figuren 3 und 4 sind die Ausführungsformen aus Fig. 1 bzw. 2 mit in die Kavität eingebrachter Rohschichtstruktur 3 ersichtlich. Die Tiefe der jeweiligen Kavität 2 ist an die Dicke der jeweiligen Schichtstruktur 3 derart angepaßt, das über der Schichtstruktur eine Restkavität 4 verbleibt.

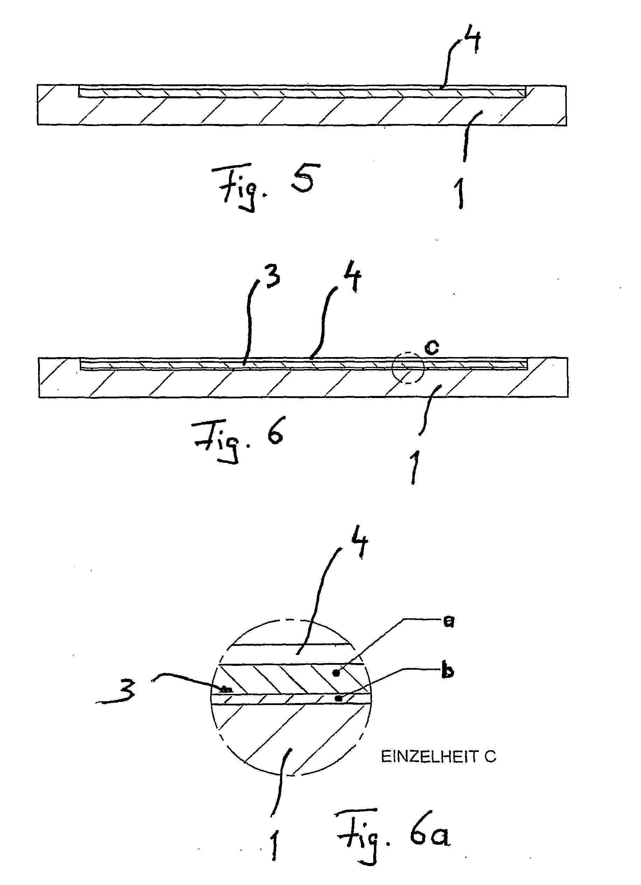

Bei der Ausführungsform aus Fig. 5 ist in die Kavität des Verdampferkörpers 1 eine einschichtige Schichtstruktur 3, und bei der Ausführungsform aus Fig. 6 und 6a eine Mehrschichtstruktur 3 mit einer oberen benetzungsfördernden Schicht a und einer unteren benetzungshemmenden und/oder elektrisch isolierenden Schicht b eingebracht.

### Beispiel 1:

Die 1 mm tiefe, 100 mm lange und 22 mm breite Mulde = Kavität eines aus Titandiborid-Bornitrid bestehenden Verdampferschiffchens mit den Abmessungen 150 x 30 x 10 mm (Figur 1) wurde mit folgender Mehrfachschichtstruktur (Figur 6) versehen:
a) Untere Schicht b:
   Die untere Schicht b wurde auf den Boden der Mulde (= Kavität) des Verdampferschiffchens mit einem Pinsel in Form eines dünnen (ca. 0,1 mm), den Boden der Kavität vollflächig bedeckenden Films aus einer wässrigen Suspension von Bornitridpulver aufgetragen und dann an Luft kurz vorgetrocknet.
b) Obere Schicht a:
   Die zweite Schicht a wurde als eine wässrige Suspension von Titandiboridpulver vollflächig und gleichmäßig in einer Dicke von 0,5 mm auf den ersten Bornitridüberzug b aufgetragen und an Luft und/oder später unter dem Vakuum-und Temperatureinfluss der Metallisierunganlage getrocknet.

Anschließend wurde das präparierte Verdampferschiffchen in der Metallisierungsanlage unter Hochvakuum auf eine Temperatur von ca. 1450 bis 1600 °C gebracht. Hierzu wurde das Verdampferschiffchen mit der aufgebrachten Schichtstruktur durch Hindurchleiten von Strom durch das Verdampferschiffchen beheizt.

Auf die aufgeheizte Schichtstruktur wurde nun kontinuierlich Aluminiumdraht zugeführt.

### Ergebnis:

Die Erstbenetzung des Aluminiums auf der Schichtstruktur ist gleichmäßig und vollflächig, so daß die Abdampfrate auf mehr als das 1,5-fache eines vergleichbaren, eingefahrenen, aber nicht beschichteten Verdampferschiffchens erhöht werden konnte. Das Aluminium verdampfte gleichmäßig ohne lokale Aluminiumseebildung, d.h. ohne Spritzerbildung, und mit relativ geringem Aufwand zur elektrischen Kontrolle.

Die Schichtstruktur hielt dem korrosiven und erosiven Angriff der Aluminiumschmelze je nach Abdampfrate 30 bis 60 Minuten stand.

Nach vollendeter Metallisierung des flexiblen Substrats wurde die kontinuierliche Drahtzufuhr gestoppt und die Leistungsaufnahme des Verdampferschiffchens inklusive Schichtstruktur wurde zum vollständigen Abdampfen des Aluminiums noch für ca. 2 Minuten aufrechterhalten.

Nun wurde die Leistung bis auf 0 kW zurückgestellt, was zur schnellen Abkühlung des Verdampferschiffchens inklusive Schichtstruktur führte. Dabei lockerte sich die Schichtstruktur vom Verdampferschiffchen meist vollständig. Sich nicht durch die Abkühlung selbst ablösende Bestandteile des Überzugs ließen sich mit geringer mechanischer Kraft mühelos entfernen, worauf das Verdampferschiffchen erneut beschichtet und mit vergleichbar gutem Erfolg betrieben werden konnte.

### Beispiel 2: Herstellung und Anwendung einer Platte aus sinterfähigem Pulvermaterial in einem Bindermaterial aus Zinn

Im Turbomischer wurde eine Pulvermischung aus 70 Gew.% Titandiborid (d90 < 50µm) und 30 Gew% Zinn (d90 < 60µm) trocken gemischt. Diese Mischung wurde dann bei 300°C mit einer beheizbaren Presse zu einer Platte der Dimension Höhe x Breite x Länge = 0,5 x 26 x 100 mm warm gepresst und anschließend in der Pressform abgekühlt und entformt.

Bei diesem Pressvorgang schmolz das Zinn und bettete das sinterfähige Pulver ein. Das sinterfähige Pulver blieb unverändert, d.h. es sinterte bei diesen niedrigen Temperaturen nicht zusammen und bildete auch keine Reaktionsprodukte mit dem Zinn. Beim Abkühlen entstand dann die Rohpulver-Zinn-Platte.

Die derart hergestellte Platte aus sinterfähigem, benetzungsfördernden Pulvermaterial (= Rohpulver) und Zinn hat einen Einschichtaufbau.

Diese Platte aus sinterfähigem, benetzungsfördernden Rohpulver und Zinn wurde in die Kavität eines aus Titandiborid-Bornitrid bestehenden Verdampferschiffchens mit den Abmessungen 150 x 30 x 10 mm und dem Kavitätsmaß 100 x 26 x 3 mm (Figur 1) gelegt. Anschließend wurde das derart präparierte Verdampferschiffchen in der Metallisierungsanlage innerhalb von 10 min. auf 1450 bis 1600 °C gebracht. Hierzu wurde das Verdampferschiffchen mit der aufgebrachten Platte aus sinterfähigem, benetzungsfördernden Rohpulver und Zinn durch Hindurchleiten von Strom durch das Verdampferschiffchen beheizt.

Beim Aufheizen schmolz das Zinn ab etwa 230°C und es bildete sich eine Rohpulver-Sn-Suspension, die einen guten thermischen Kontakt zum Verdampferkörper herstellte. Ab etwa 600°C begann dar benetzungsfördernde Pulver in der Umgebung des flüssigen Zinns zu sintern. Das flüssige Zinn nahm nicht aktiv an dem Sinterprozess teil. Der Sinterprozess war bei etwa 1400 °C abgeschlossen. In Abhängigkeit vom Vakuum in der Metallisierungsanlage verdampfte das Zinn bei etwa 1200 bis 1400 °C vollständig.

Zurück blieb dann die aufgesinterte korrosionsfeste benetzungsfördernde Beschichtung, auf die dann kontinuierlich Aluminiumdraht gegeben wurde.

Konzentrationen/Schichtdicken/Korngrößen etc.:
- Konzentration des Zinnpulvers in der Zinn-Rohpulver-Mischung: 10 bis 50 Gew% (vorzugsweise 20 bis 40 Gew.%)
- Korngröße des Zinnpulvers: d90 = 20 bis 200 µm (vorzugsweise 40 bis 80 µm)
- Plattendicke: 0,2 bis 1,5 mm (vorzugsweise 0,4 bis 1,0 mm)

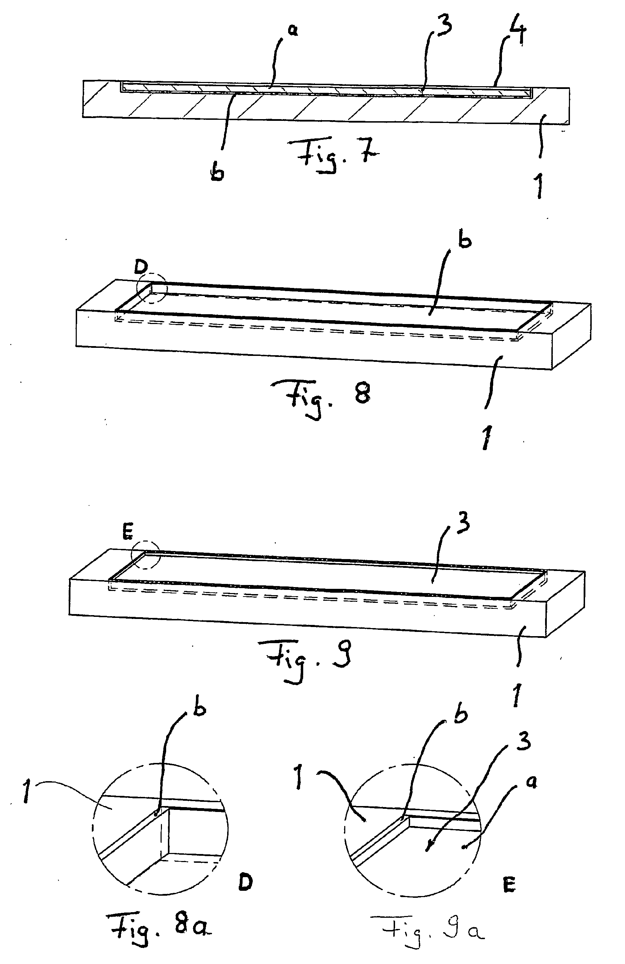

Bei der in Fig. 7, 9 und 9a gezeigten Ausführungsform ist in die Kavität des Verdampferkörpers 1 eine zweischichtige Schichtstruktur 3 mit, wie insbesondere aus Fig. 7 und 9a ersichtlich, einer wannenförmigen, die Begrenzungsfläche der Kavität allseitig abdeckenden benetzungshemmenden und/oder elektrisch isolierenden Schicht b und einer oberen benetzungsfördernden Schicht a eingebracht, welche in der durch die wannenförmige Schicht b ausgebildeten Wanne aufgenommenen ist. Die Wannenform der Schicht b hat insbesondere bei elektrisch isolierendem Schichtmaterial den Vorteil, dass die benetzungsfördernde Schicht auch umfangseitig von der Begrenzungswand der Kavität des Verdampferkörpers 1 isoliert ist, wodurch besser verhindert wird, dass Strom durch das auf der benetzungsfördernden Schicht a aufgebrachte Verdampfungsmaterial fließt.

Die Figuren 8 und 8a zeigen den Verdampferkörper 1 beim Herrichtvorgang, mit zu diesem Zeitpunkt nur in die Kavität wannenförmig eingebrachter benetzungshemmender bzw. elektrisch isolierenden Schicht b, auf welche dann die benetzungsfördernde Schicht a aufzutragen ist.

Nach dem Aufbringen der Schicht a verbleibt dann wie in den vorigen Beispielen wiederum eine Restkavität 4 mit umfangsseitig von der Schicht b gebildeter Begrenzungsfläche.

## Patentansprüche

1. Verfahren zum Herrichten eines Verdampferkörpers, insbesondere eines keramischen Verdampferkörpers, und dessen Betreiben in einer PVD-Metallisierungsanlage, bei welchem auf den Verdampferkörper eine Schichtstruktur aus mindestens einer Schicht aufgebracht wird und ein Metallisierungszyklus durchgeführt wird, in welchem der Verdampferkörper mit elektrischem Strom betrieben wird und kontinuierlich mit Metall beschickt wird, so daß der Verdampferkörper aufgrund seines elektrischen Widerstands erwärmt wird und das der Schichtstruktur zugeführte Metall verdampft wird, **dadurch gekennzeichnet, daß** als Schichtstruktur eine durch den Betrieb des Verdampferkörpers verbrauchbare Schichtstruktur verwendet wird, die auf den Verdampferkörper vor dem Metallisierungszyklus als Rohschichtstruktur in Form einer vorgefertigten Platte aus sinterfähigem Pulvermaterial im im wesentlichen unversinterten Zustand oder aus in einem niedrigschmelzenden Bindermaterial verteiltenm sinterfähigen Pulvermaterial im im wesentlichen ungesinterten Zustand aufgebracht wird und in dem Metallisierungszyklus durch die Erwärmung des Verdampferkörpers auf diesen aufgesintert wird.

2. Verfahren nach Anspruch 1, wobei das Aufbringen der Rohschichtstruktur durch Einbringen der Platte aus dem Pulvermaterial in eine Kavität des Verdampferkörpers durchgeführt wird.

3. Verfahren nach Anspruch 2, wobei der Verdampferkörper mit einer Kavität mit flachem hohlen Rechteckquerschnitt ausgestattet wird, der mit der Platte aus dem Pulvermaterial bis auf eine Restkavität mit einer Tiefe von 0,3 bis 3 mm, vorzugsweise von 0,5 bis 0,8 mm aufgefüllt wird.

4. Verfahren nach einem der Ansprüche 1 bis 34, wobei die Rohschichtstruktur, die verwendet wird, aus mehreren übereinanderliegenden Schichten besteht

5. Verfahren nach Anspruch 4, wobei die Rohschichtstruktur, die verwendet wird, in Anpassung an das zu verdampfende Metall mit einer oberen benetzungsfördernden Schicht aus dem sinterfähigen Pulvermaterial oder aus dem sinterfähigen Pulvermaterial in niedrigschmelzendem Bindermaterial und mit einer unteren benetzungshemmenden und/oder elektrisch isolierenden Schicht besteht.

6. Verfahren nach einem der Ansprüche 1 bis 5, wobei die Rohschichtenstruktur, die verwendet wird, eine Gesamtdicke von 0,2 bis 1,5 mm, vorzugsweise von 0,6 bis 1,0 mm aufweist.

7. Verfahren nach einem der Ansprüche 1 bis 67, wobei die Rohschichtstruktur, die verwendet wird, einen Wärmeausdehnungskoeffizienten hat, der von dem Wärmeausdehnungskoeffizienten des Verdampferkörpers verschieden ist, so daß ein Ablösen der verbrauchten Schichtstruktur von dem Verdampferkörper durch dessen Abkühlen gefördert wird.

8. Verfahren nach einem der Ansprüche 1 bis 7, wobei der Verdampferkörper, der verwendet wird, aus einer Mischkeramik mit den Hauptkomponenten TiB₂, BN und/oder AlN oder aus einer Keramik-Metall-Mischung mit den Hauptkomponenten ZrO₂ und Mo oder aus einem Material mit Kohlenstoff als Hauptkomponente besteht.

9. Verfahren nach einem der Ansprüche 1 bis 8, wobei die Rohschichtstruktur eine benetzungsfördernde Schicht aus einem Pulvermaterial aus hochschmelzendem Borid oder Carbid oder Nitrid oder Silicid der IV, V und VI Nebengruppe oder Zirkonoxid oder aus einer stabilen Mischphase von wenigstens zwei dieser Verbindungen oder aus einer stabilen Mischphase mit wenigstens einer dieser Verbindungen mit Aluminiumnitrid oder aus Molybdän oder Wolfram oder Titan aufweist.

10. Verfahren nach einem der Ansprüche 5 bis 9, wobei als isolierende und/oder benetzungshemmende Schicht ein Pulvermaterial aus der Gruppe aus Bornitrid, Aluminiumnitrid, Siliziumnitrid, hochschmelzende Oxide (wie Aluminiumoxid, Yttriumoxid), Aluminiumtitanat, Zirkonsilikat, oder aus einer Mischphase wenigstens zweier dieser Verbindungen verwendet wird.

11. Verfahren nach einem der Ansprüche 1 bis 8, wobei zum Verdampfen eines Metalls aus der Gruppe aus Aluminium, Kupfer, Zinn, Silber, Gold, oder aus einer Mischung wenigstens zweier dieser Metalle oder aus einer Legierung wenigstens zweier dieser Metalle eine Rohschichtstruktur nach Arispruch 9 oder 10 verwendet wird.

12. Verfahren nach einem der Ansprüche 1 bis 11, wobei als niedrigschmelzendes Bindermaterial Zinn verwendet wird.

13. Verfahren nach Anspruch 12, wobei das Zinn als mit dem sinterfähigen Pulvermaterial vermischtes oder verpreßtes Pulvermaterial vorliegt.

14. Verfahren nach Anspruch 12, wobei das Zinn als Gußmaterial mit darin verteiltem sinterfähigem Pulvermaterial vorliegt.

15. Verfahren nach einem der Ansprüche 1 bis 14, wobei nach Beendigung eines ersten Metallisierungszyklus die verbrauchte Schichtstruktur von dem abgekühlten Verdampferkörper innerhalb der Metallisierungsanlage entfernt und durch eine frische Rohschichtstruktur zur Herrichtung des Verdampferkörpers für einen zweiten Metallisierungszyklus und zum Betreiben des Verdampferkörpers in dem zweiten Metallisierungszyklus ersetzt wird.

16. Verfahren zum Herrichten eines Verdampferkörpers, insbesondere eines keramischen Verdampferkörpers, und dessen Betreiben in einer PVD-Metallisierungsanlage, bei welchem auf den Verdampferkörper eine Schichtstruktur aus mindestens zwei Schichten aufgebracht wird und ein Metallisierungszyklus durchgeführt wird, in welchem der Verdampferkörper mit elektrischem Strom betrieben wird und kontinuierlich mit Metall beschickt wird, so daß der Verdampferkörper aufgrund seines elektrischen Widerstands erwärmt wird und das auf die Schichtstruktur zugeführte Metall verflüssigt und verdampft wird, **dadurch gekennzeichnet, daß** als Schichtstruktur eine durch den Betrieb des Verdampferkörpers verbrauchbare Schichtstruktur verwendet wird, die auf den Verdampferkörper vor dem Metallisierungszyklus als Rohschichtstruktur aufgebracht wird, die eine obere Schicht aus einem benetzungsfördernden Plattenmaterial und eine untere elektrische isolierende und/oder benetzungshemmende Schicht aus sinterfähigem Pulvermaterial im im wesentlichen unversinterten Zustand aufweist, und in dem Metallisierungszyklus durch die Erwärmung des Verdampfungskörpers auf diesen aufgesintert wird.

17. Verfahren nach Anspruch 5 oder 16, wobei das Aufbringen der Rohschichtstruktur durch Einbringen der unteren Schicht in eine Kavität des Verdampfungskörpers in wannenförmiger Gestalt und durch Einbringen der oberen Schicht in die wannenförmige untere Schicht erfolgt, so daß die obere Schicht an der Unterseite und entlang ihres Umfangs von der unteren Schicht umgeben ist.

18. Verfahren nach Anspruch 17, wobei das Plattenmaterial der oberen Schicht als vorgefertigte Platte aus sinterfähigem, jedoch im wesentlichen unversinterten Pulvermaterial in Zinn als Bindermaterial ausgebildet ist.

19. Vorgefertigte Platte als Schichtstruktur zum Aufbringen auf einen elektrisch betreibbaren, insbesondere keramischen Verdampferkörper für eine PVD-Metallisierungsanlage, mit einer sinterfähigen Rohschichtstruktur nach Anspruch 1 oder einem der Ansprüche 4 bis 7 oder 9 bis 14 oder 17 aus einem sinterfähigen Pulvermaterial im im wesentlichen unversinterten Zustand oder aus in einem niedrigschmelzenden Bindermaterial verteiltem sinterfähigen Pulvermaterial im im wesentlichen unversinterten Zustand.

20. Vorgefertigte Platte nach Anspruch 19 in verpreßtem, insbesondere warmverpreßtem Zustand.

21. Vorgefertigte Platte nach Anspruch 19 oder 20, bei welcher das niedrigschmelzende Bindermaterial in Form von Zinn vorliegt.

22. Vorgefertigte Platte nach Anspruch 19, bei welcher das niedrigschmelzende Bindermaterial in Form von Gußmaterial aus Zinn vorliegt.

23. Verfahren zum Herrichten eines Verdampferkörpers, insbesondere eines keramischen Verdampferkörpers, und dessen Betreiben in einer PVD-Metallisierungsanlage, bei welchem auf den Verdampferkörper eine Schichtstruktur aus mindestens einer Schicht aufgebracht wird und ein Metallisierungszyklus durchgeführt wird, in welchem der Verdampferkörper mit elektrischem Strom betrieben wird und kontinuierlich mit Metall beschickt wird, so daß der Verdampferkörper aufgrund seines elektrischen Widerstands erwärmt wird und das der Schichtstruktur zugeführte Metall verdampft wird, **dadurch gekennzeichnet, daß** als Schichtstruktur eine durch den Betrieb des Verdampferkörpers verbrauchbare Schichtstruktur verwendet wird, die auf den Verdampferkörper vor dem Metallisierungszyklus als Rohschichtstruktur aus in einem niedrigschmelzenden Bindermaterial aus Zinn verteilten sinterfähigen Pulvermaterial im im wesentlichen ungesinterten Zustand aufgebracht wird und in dem Metallisierungszyklus durch die Erwärmung des Verdampferkörpers auf-diesen aufgesintert wird.

24. Verfahren nach Anspruch 23, wobei das Zinn als mit dem Pulvermaterial vermischtes oder verpreßtes Pulvermaterial oder als Gußmaterial mit darin verteiltem sinterfähigen Pulvermaterial vorliegt.

25. Verfahren nach Anspruch 23 oder 24, wobei die Rohschichtstruktur auf den Verdampferkörper in Form einer Suspension mit einem zugemischten verdampfbaren Medium, wie Wasser oder Ethanol, aufgebracht wird.

26. Verfahren nach einem der Ansprüche 23 bis 25, wobei das Aufbringen der Rohschichtstruktur durch Einbringen des Pulvermaterials in eine Kavität des Verdampferkörpers durchgeführt wird.

27. Verfahren nach Anspruch 26, wobei der Verdampferkörper mit einer Kavität mit flachem hohlen Rechteckquerschnitt ausgestattet wird, der mit der Platte aus dem Pulvermaterial bis auf eine Restkavität mit einer Tiefe von 0,3 bis 3 mm, vorzugsweise von 0,5 bis 0,8 mm aufgefüllt wird.

28. Verfahren nach einem der Ansprüche 23 bis 27, wobei als die Rohschichtstruktur eine Rohschichtstruktur nach einem der Ansprüche 4 bis 7, 9 bis 11 verwendet wird.

29. Verfahren nach einem der Ansprüche 23 bis 28, wobei als die Rohschichtstruktur eine Rohschichtstruktur aus mehreren übereinanderliegenden Schichten mit, in Anpassung an das zu verdampfende Metall, einer oberen benetzungsfördernden Schicht aus dem sinterfähigen Pulvermaterial in niedrigschmelzendem Bindermaterial aus Zinn und mit einer unteren benetzungshemmenden und/oder elektrisch isolierenden Schicht verwendet wird, wobei das Aufbringen der Rohschichtstruktur durch Einbringen der unteren Schicht in eine Kavität des Verdampfungskörpers in wannenförmiger Gestalt und durch Einbringen der oberen Schicht in die wannenförmige untere Schicht erfolgt, so daß die obere Schicht an der Unterseite und entlang ihres Umfangs von der unteren Schicht umgeben ist.

30. Verfahren nach einem der Ansprüche 23 bis 29, wobei nach Beendigung eines ersten Metallisierungszyklus die verbrauchte Schichtstruktur von dem abgekühlten Verdampferkörper innerhalb der Metallisierungsanlage entfernt und durch eine frische Rohschichtstruktur zur Herrichtung des Verdampferkörpers für einen zweiten Metallisierungszyklus und zum Betreiben des Verdampferkörpers in dem zweiten Metallisierungszyklus ersetzt wird.

## Claims

1. Process for preparing a vaporizer body, especially a ceramic vaporizer body, and operation thereof in a PVD metallization system, in which a layer structure composed of at least one layer is applied to the vaporizer body and a metallization cycle is performed, in which the vaporizer body is operated with electrical current and is charged continuously with metal, such that the vaporizer body is heated due to its electrical resistance and the metal supplied to the layer structure is vaporized, **characterized in that** the layer structure used is a layer structure which can be consumed by the operation of the vaporizer body and which is applied to the vaporizer body before the metallization cycle as a layer structure precursor in the form of a prefabricated sheet of sinterable powder material in the essentially unsintered state, or of sinterable powder material in the essentially unsintered state distributed in a low-melting binder material, and is sintered onto the vaporizer body as a result of the heating thereof in the metallization cycle.

2. Process according to Claim 1, wherein the application of the layer structure precursor is performed by introducing the sheet of powder material into a cavity of the vaporizer body.

3. Process according to Claim 2, wherein the vaporizer body is equipped with a cavity with a flat hollow rectangular cross section which is filled with the sheet of the powder material apart from a residual cavity with a depth of 0.3 to 3 mm, preferably of 0.5 to 0.8 mm.

4. Process according to any of Claims 1 to 3, wherein the layer structure precursor which is used consists of several layers one on top of another.

5. Process according to Claim 4, wherein the layer structure precursor which is used, according to the metal to be vaporized with an upper wetting-promoting layer, consists of the sinterable powder material or of the sinterable powder material in low-melting binder material and with a lower wetting-inhibiting and/or electrically insulating layer.

6. Process according to any of Claims 1 to 5, wherein the layer structure precursor which is used has a total thickness of 0.2 to 1.5 mm, preferably of 0.6 to 1.0 mm.

7. Process according to any of Claims 1 to 6, wherein the layer structure precursor which is used has a coefficient of thermal expansion different from the coefficient of thermal expansion of the vaporizer body, such that detachment of the consumed layer structure from the vaporizer body is promoted by the cooling thereof.

8. Process according to any of Claims 1 to 7, wherein the vaporizer body which is used consists of a mixed ceramic with the main components TiB₂, BN and/or AlN or of a ceramic-metal mixture with the main components ZrO₂ and Mo or of a material with carbon as the main component.

9. Process according to any of Claims 1 to 8, wherein the layer structure precursor has a wetting-promoting layer of a powder material composed of high-melting boride or carbide or nitride or silicide of transition group IV, V and VI, or zirconium oxide, or of a stable mixed phase of at least two of these compounds or of a stable mixed phase comprising at least one of these compounds with aluminium nitride, or of molybdenum or tungsten or titanium.

10. Process according to any of Claims 5 to 9, wherein the insulating and/or wetting-inhibiting layer used is a powder material from the group of boron nitride, aluminium nitride, silicon nitride, high-melting oxides (such as aluminium oxide, yttrium oxide), aluminium titanate, zirconium silicate, or of a mixed phase of at least two of these compounds.

11. Process according to any of Claims 1 to 8, wherein a layer structure precursor according to Claim 9 or 10 is used for vaporization of a metal from the group of aluminium, copper, tin, silver, gold, or a mixture of at least two of these metals or an alloy of at least two of these metals.

12. Process according to any of Claims 1 to 11, wherein the low-melting binder material used is tin.

13. Process according to Claim 12, wherein the tin is present as a powder material mixed or pressed with the sinterable powder material.

14. Process according to Claim 12, wherein the tin is present as a cast material with sinterable powder material distributed therein.

15. Process according to any of Claims 1 to 14, wherein ending of a first metallization cycle is followed by removal of the consumed layer structure from the cooled vaporizer body within the metallization system, and replacement by a fresh layer structure precursor to prepare the vaporizer body for a second metallization cycle and to operate the vaporizer body in the second metallization cycle.

16. Process for preparing a vaporizer body, especially a ceramic vaporizer body, and operation thereof in a PVD metallization system, in which a layer structure composed of at least two layers is applied to the vaporizer body and a metallization cycle is performed, in which the vaporizer body is operated with electrical current and is charged continuously with metal, such that the vaporizer body is heated due to its electrical resistance and the metal supplied to the layer structure is liquefied and vaporized, **characterized in that** the layer structure used is a layer structure which can be consumed by the operation of the vaporizer body and which is applied to the vaporizer body before the metallization cycle as a layer structure precursor which has an upper layer of a wetting-promoting sheet material and a lower electrically insulating and/or wetting-inhibiting layer of sinterable powder material in the essentially unsintered state, and is sintered onto the vaporization body by the heating thereof in the metallization cycle.

17. Process according to Claim 5 or 16, wherein the layer structure precursor is applied by introducing the lower layer into a cavity of the vaporization body in a trough shape and by introducing the upper layer into the trough-shaped lower layer, such that the upper layer is surrounded by the lower layer on the underside and along its periphery.

18. Process according to Claim 17, wherein the sheet material of the upper layer is configured as a prefabricated sheet of sinterable but essentially unsintered powder material in tin as a binder material.

19. Prefabricated sheet as a layer structure for application onto an electrically operable, especially ceramic vaporizer body for a PVD metallization system, comprising a sinterable layer structure precursor according to Claim 1 or any of Claims 4 to 7 or 9 to 14 or 17 composed of a sinterable powder material in the essentially unsintered state or of sinterable powder material distributed in a low-melting binder material in the essentially unsintered state.

20. Prefabricated sheet according to Claim 19 in the pressed, especially hot-pressed, state.

21. Prefabricated sheet according to Claim 19 or 20, in which the low-melting binder material is in the form of tin.

22. Prefabricated sheet according to Claim 19, in which the low-melting binder material is in the form of cast tin material.

23. Process for preparing a vaporizer body, especially a ceramic vaporizer body, and operation thereof in a PVD metallization system, in which a layer structure composed of at least one layer is applied to the vaporizer body and a metallization cycle is performed, in which the vaporizer body is operated with electrical current and is charged continuously with metal, such that the vaporizer body is heated due to its electrical resistance and the metal supplied to the layer structure is vaporized, **characterized in that** the layer structure used is a layer structure which can be consumed by the operation of the vaporizer body and which is applied to the vaporizer body before the metallization cycle as a layer structure precursor composed of sinterable powder material in the essentially unsintered state distributed in a low-melting binder material composed of tin, and is sintered onto the vaporizer body by the heating thereof in the metallization cycle.

24. Process according to Claim 23, wherein the tin is in the form of powder material mixed or pressed with the powder material, or as a cast material with sinterable powder material distributed therein.

25. Process according to Claim 23 or 24, wherein the layer structure precursor is applied to the vaporizer body in the form of a suspension with an added vaporizable medium such as water or ethanol.

26. Process according to any of Claims 23 to 25, wherein the application of the layer structure precursor is performed by introducing the powder material into a cavity of the vaporizer body.

27. Process according to Claim 26, wherein the vaporizer body is equipped with a cavity with a flat hollow rectangular cross section which is filled with the sheet of the powder material apart from a residual cavity with a depth of 0.3 to 3 mm, preferably of 0.5 to 0.8 mm.

28. Process according to any of Claims 23 to 27, wherein the layer structure precursor used is a layer structure precursor according to any of Claims 4 to 7, 9 to 11.

29. Process according to any of Claims 23 to 28, wherein the layer structure precursor used is a layer structure precursor composed of several layers one on top of another with, according to the metal to be vaporized, an upper wetting-promoting layer of the sinterable powder material in low-melting binder material composed of tin and with a lower wetting-inhibiting and/or electrically insulating layer, wherein the layer structure precursor is applied by introducing the lower layer into a cavity of the vaporizer body in a trough shape and by introducing the upper layer into the trough-shaped lower layer, such that the upper layer is surrounded by the lower layer on the underside and along the periphery thereof.

30. Process according to any of Claims 23 to 29, wherein ending of a first metallization cycle is followed by removal of the consumed layer structure from the cooled vaporizer body within the metallization system and replacement by a fresh layer structure precursor to prepare the vaporizer body for a second metallization cycle and to operate the vaporizer body in the second metallization cycle.

## Revendications

1. Procédé pour la préparation d'un corps d'évaporateur, en particulier d'un corps d'évaporateur en céramique, et pour son utilisation dans une installation de métallisation par PVD, dans lequel
une structure stratifiée constituée d'au moins une couche est appliquée sur le corps d'évaporateur et
un cycle de métallisation au cours duquel le corps d'évaporateur est alimenté en courant électrique et est revêtu en continu de métal est exécuté de telle sorte que le corps d'évaporateur soit chauffé du fait de sa résistance électrique et que le métal apporté sur la structure stratifiée soit évaporé,
**caractérisé en ce que**
il utilise comme structure stratifiée une structure stratifiée qui peut être consommée lorsque le corps d'évaporateur est en fonctionnement et qui est appliquée sur le corps d'évaporateur avant le cycle de métallisation sous la forme d'une structure stratifiée brute en plaque pré-fabriquée constituée d'un matériau poudreux frittable à l'état essentiellement non fritté ou en matériau poudreux frittable réparti dans un matériau de liant à bas point de fusion et fritté sur le corps d'évaporateur par l'échauffement du corps d'évaporateur lors du cycle de métallisation.

2. Procédé selon la revendication 1, dans lequel l'application de la structure stratifiée brute est réalisée par insertion de la plaque en matériau poudreux dans une cavité du corps d'évaporateur.

3. Procédé selon la revendication 2, dans lequel le corps d'évaporateur est doté d'une cavité de section transversale rectangulaire creuse aplatie qui est remplie par la plaque en matériau poudreux jusqu'à laisser une cavité résiduelle d'une profondeur de 0,3 à 3 mm et de préférence de 0,5 à 0,8 mm.

4. Procédé selon l'une des revendications 1 à 3, dans lequel la structure stratifiée brute utilisée est constituée de plusieurs couches superposées.

5. Procédé selon la revendication 4, dans lequel la structure stratifiée brute utilisée est constituée, de manière adaptée au métal à vaporiser, d'une couche supérieure qui favorise le mouillage, en le matériau poudreux frittable, du matériau poudreux frittable placé dans un matériau de liant à bas point de fusion et d'une couche inférieure qui inhibe le mouillage et/ou qui est électriquement isolante.

6. Procédé selon l'une des revendications 1 à 5, dans lequel la structure stratifiée brute utilisée présente une épaisseur totale comprise entre 0,2 et 1,5 mm et de préférence entre 0,6 et 1,0 mm.

7. Procédé selon l'une des revendications 1 à 6, dans lequel la structure stratifiée brute utilisée possède un coefficient de dilatation thermique différent du coefficient de dilatation thermique du corps d'évaporateur de manière à favoriser le détachement de la structure stratifiée consommée du corps d'évaporateur lors du refroidissement de ce dernier.

8. Procédé selon l'une des revendications 1 à 7, dans lequel le corps d'évaporateur utilisé est constitué d'une céramique mixte dont les composants principaux sont TiB₂, BN et/ou AlN, d'un mélange métal-céramique dont les composants principaux sont ZrO₂ et Mo ou d'un matériau dont le composant principal est le carbone.

9. Procédé selon l'une des revendications 1 à 8, dans lequel la structure stratifiée brute présente une couche favorisant le mouillage constituée d'un matériau poudreux à haut point de fusion en borure, carbure, nitrure ou siliçure des groupes voisins IV, V et VI, en oxyde de zirconium, en une phase mixte stable d'au moins deux de ces composants ou en une phase mixte qui présente au moins l'un de ces composants ainsi que de nitrure d'aluminium, de molybdène, de tungstène ou de titane.

10. Procédé selon l'une des revendications 5 à 9, qui utilise comme couche isolante et/ou inhibant le mouillage un matériau poudreux de l'ensemble constitué du nitrure de bore, du nitrure d'aluminium, du nitrure de silicium, des oxydes à haut point de fusion (par exemple l'oxyde d'aluminium, l'oxyde d'yttrium), du titanate d'aluminium, du silicate de zirconium ou d'une phase mixte d'au moins deux de ces composés.

11. Procédé selon l'une des revendications 1 à 8, qui utilise une structure stratifiée brute selon les revendications 9 ou 10 pour vaporiser un métal de l'ensemble constitué de l'aluminium, du cuivre, du zinc, de l'argent, de l'or, d'un mélange d'au moins deux de ces métaux ou d'un alliage d'au moins deux de ces métaux.

12. Procédé selon l'une des revendications 1 à 11, qui utilise l'étain comme matériau de liant à bas point de fusion.

13. Procédé selon la revendication 12, dans lequel l'étain est présent sous la forme d'un matériau poudreux mélangé ou comprimé avec le matériau poudreux frittable.

14. Procédé selon la revendication 12, dans lequel l'étain présente la forme d'un matériau coulé dans lequel est réparti le matériau poudreux frittable.

15. Procédé selon l'une des revendications 1 à 14, dans lequel, après la fin d'un premier cycle de métallisation, la structure stratifiée consommée est enlevée du corps d'évaporateur refroidi à l'intérieur de l'installation de métallisation et est remplacée par une structure stratifiée brute fraîche en vue de préparer le corps d'évaporateur à un deuxième cycle de métallisation et d'utiliser le corps d'évaporateur dans le deuxième cycle de métallisation.

16. Procédé pour la préparation d'un corps d'évaporateur, en particulier d'un corps d'évaporateur en céramique et pour son utilisation dans une installation de métallisation par PVD, dans lequel une structure stratifiée constituée d'au moins deux couches est appliquée sur le corps d'évaporateur et un cycle de métallisation au cours duquel le corps d'évaporateur est alimenté en courant électrique et est revêtu en continu de métal est exécuté, de telle sorte que du fait de sa résistance électrique, le corps d'évaporateur soit chauffé et que le métal apporté sur la structure stratifiée soit liquéfié et vaporisé, **caractérisé en ce que**
il utilise comme structure stratifiée une structure stratifiée consommée lors du fonctionnement du corps d'évaporateur et appliquée sur le corps d'évaporateur sous la forme d'une structure stratifiée brute avant le cycle de métallisation, la structure stratifiée présentant une couche supérieure en un matériau en plaque qui favorise le mouillage et une couche inférieure électriquement isolante et/ou inhibant le mouillage, en matériau poudreux frittable à l'état essentiellement non fritté et fritté sur le corps d'évaporateur par l'échauffement de ce dernier au cours du cycle de métallisation.

17. Procédé selon les revendications 5 ou 16, dans lequel l'application de la structure stratifiée brute s'effectue en plaçant la couche inférieure dans une cavité en forme de cuvette du corps d'évaporateur et en plaçant la couche supérieure dans la couche inférieure en forme de cuvette de telle sorte que la couche supérieure soit entourée par la couche inférieure sur son côté inférieur et le long de sa périphérie.

18. Procédé selon la revendication 17, dans lequel le matériau en plaque de la couche supérieure est configuré comme plaque pré-fabriquée en matériau poudreux frittable mais essentiellement non fritté, placé dans l'étain servant de matériau de liant.

19. Plaque pré-fabriquée servant de structure stratifiée destinée à être placée sur un corps d'évaporateur apte à être alimenté en électricité et en particulier en céramique pour une installation de métallisation par PVD, et présentant une structure stratifiée brute frittable selon la revendication 1 ou l'une des revendications 4 à 7, 9 à 14 ou 17, en un matériau poudreux frittable à l'état essentiellement non fritté ou en un matériau poudreux frittable à l'état essentiellement non fritté réparti dans un matériau de liant à bas point de fusion.

20. Plaque pré-fabriquée selon la revendication 19 à l'état comprimé et en particulier comprimé à chaud.

21. Plaque pré-fabriquée selon les revendications 19 ou 20, dans laquelle le matériau de liant à bas point de fusion présente la forme de l'étain.

22. Plaque pré-fabriquée selon la revendication 19, dans laquelle le matériau de liant à bas point de fusion présente la forme d'un matériau coulé en étain.

23. Procédé pour la préparation d'un corps d'évaporateur, en particulier d'un corps d'évaporateur en céramique, et pour son utilisation dans une installation de métallisation par PVD, dans lequel
une structure stratifiée constituée d'au moins une couche est appliquée sur le corps d'évaporateur et
un cycle de métallisation au cours duquel le corps d'évaporateur est alimenté en courant électrique et est revêtu en continu de métal est exécuté de telle sorte que le corps d'évaporateur soit chauffé du fait de sa résistance électrique et que le métal apporté sur la structure stratifiée soit évaporé,
**caractérisé en ce que**
il utilise comme structure stratifiée une structure stratifiée qui peut être consommée lorsque le corps d'évaporateur est en fonctionnement et qui est appliquée sur le corps d'évaporateur avant le cycle de métallisation sous la forme d'une structure stratifiée brute en un matériau poudreux frittable réparti à l'état essentiellement non fritté dans un matériau de liant en étain à bas point de fusion et fritté sur le corps d'évaporateur par l'échauffement de ce dernier lors du cycle de métallisation.

24. Procédé selon la revendication 23, dans lequel l'étain présente la forme d'un matériau poudreux mélangé ou comprimé avec le matériau poudreux ou sous la forme d'un matériau coulé dans lequel un matériau poudreux frittable est réparti.

25. Procédé selon les revendications 23 ou 24, dans lequel la structure stratifiée brute est appliquée sur le corps d'évaporateur sous la forme d'une suspension à laquelle est ajouté un fluide vaporisable, par exemple l'eau ou l'éthanol.

26. Procédé selon l'une des revendications 23 à 25, dans lequel l'application de la structure stratifiée brute est réalisée en insérant le matériau poudreux dans une cavité du corps d'évaporateur.

27. Procédé selon la revendication 26, dans lequel le corps d'évaporateur est doté d'une cavité de section transversale rectangulaire creuse aplatie qui est remplie par la plaque en matériau poudreux jusqu'à laisser une cavité résiduelle d'une profondeur de 0,3 à 3 mm et de préférence de 0,5 à 0,8 mm.

28. Procédé selon l'une des revendications 23 à 27, qui utilise comme structure stratifiée brute une structure stratifiée brute selon l'une des revendications 4 à 7 ou 9 à 11.

29. Procédé selon l'une des revendications 23 à 28, qui utilise comme structure stratifiée brute une structure stratifiée brute constituée de plusieurs couches superposées qui, de manière adaptée au métal à vaporiser, présente une couche supérieure favorisant le mouillage, en le matériau poudreux fritté dans un matériau de liant en étain à bas point de fusion et une couche inférieure inhibant le mouillage et/ou électriquement isolante, l'application de la structure stratifiée brute s'effectuant en plaçant la couche inférieure dans une cavité en forme de cuvette du corps d'évaporateur et en plaçant la couche supérieure dans la couche inférieure en forme de cuvette de telle sorte que la couche supérieure soit entourée par la couche inférieure sur son côté inférieur et le long de sa périphérie.

30. Procédé selon l'une des revendications 23 à 29, dans lequel, après la fin d'un premier cycle de métallisation, la structure stratifiée consommée est enlevée du corps d'évaporateur refroidi à l'intérieur de l'installation de métallisation et est remplacée par une structure stratifiée brute fraîche en vue de préparer le corps d'évaporateur à un deuxième cycle de métallisation et d'utiliser le corps d'évaporateur dans le deuxième cycle de métallisation.
